Europäisches Patentamt

European Patent Office

Office européen des brevets

Publication number: **0 297 325**
**A2**

# EUROPEAN PATENT APPLICATION

Application number: 88109214.2

Date of filing: 09.06.88

Int. Cl.⁴ **H01L 29/74 , H01L 29/32 , H01L 29/167 , H01L 21/265 , H01L 29/10**

Priority: 01.07.87 JP 164425/87

Date of publication of application:
**04.01.89 Bulletin 89/01**

Designated Contracting States:
**DE FR GB**

Applicant: **MITSUBISHI DENKI KABUSHIKI KAISHA**
**2-3, Marunouchi 2-chome Chiyoda-ku Tokyo 100(JP)**

Inventor: **Hagino, Hiroyasu c/o Mitsubishi Denki K.K.**
**Kitaitami Seisakusho 1, Mizuhara 4-chome Itami-shi Hyogo(JP)**

Representative: **Sajda, Wolf E., Dipl.-Phys. et al**
**MEISSNER, BOLTE & PARTNER**
**Widenmayerstrasse 48 Postfach 86 06 24**
**D-8000 München 86(DE)**

Gate turn-off thyristor and manufacturing method thereof.

A gate turn-off thyristor has a damage layer (29), which provides recombination centers for trapping carriers, in an n-type base layer (21). Carriers remaining in the n-type base layer (21) are quickly swept out at the time of turn-off operation by virtue of the damage layer (29), so that the turn-off time of the thyristor can be reduced.

*FIG.2*

# Gate Turn-Off Thyristor and Manufacturing Method thereof

## BACKGROUND OF THE INVENTION

### Field of the Invention

The present invention relates to a power gate turn-off thyristor and, more particularly, it relates to an improvement in a trade-off of the ON voltage and the switching time of a gate turn-off thyristor.

### Description of the Background Art

A gate turn-off thyristor is a self-arc-suppressing device which is easily enhanced in current capacity and breakdown voltage. Recently, a gate turn-off thyristor is practically used in various fields, because of the improvement of characteristics thereof.

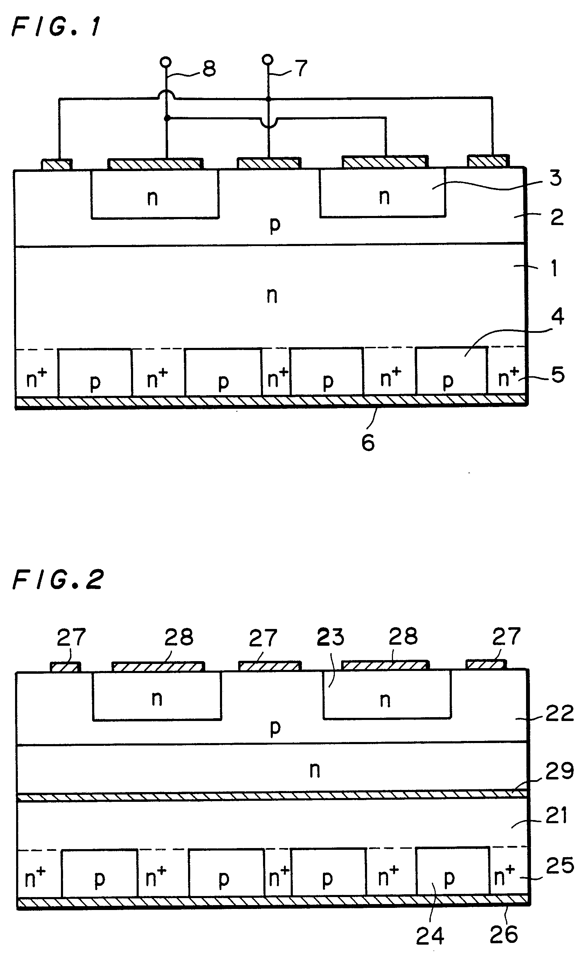

Fig. 1 is a cross-sectional view showning an anode-shorted structure which is employed in a conventional gate turn-off thyristor for an improvement of a trade-off of the ON voltage and the switching time of the gate turn-off thyristor. Referring to Fig. 1, p-type emitter layers 4 and $n^+$-type shorting layers 5 are alternately formed on one major surface of an n-type semiconductor substrate serving as an n-type base layer 1. An anode electrode 6, which is formed on the p-type emitter layers 4 and the $n^+$-type shorting layers 5, short-circuits the p-type emitter layers 4 and the $n^+$-type shorting layers 5. A p-type base layer 2 is provided on the other major surface of the n-type base layer 1, and n-type emitter layers 3 are provided in the surface of the p-type base layer 2. A gate electrode 7 and a cathode electrode 8 are in ohmic contact with the p-type base layer 2 and the n-type emitter layers 3, respectively.

The gate turn-off thyristor having the anode-shorted structure has a characteristic such that the turn-off time thereof can be reduced without shortening the life time of carriers in the n-type base layer 1. The reason why the turn-off time becomes short even if the life time of carriers is long is that carriers remaining in the n-type base layer 1 are drawn out to the anode electrode 6 through the $n^+$-type shorting layer 5 at the time of turn off operation. Further, the gate turn-off thyristor having the anode shorted structure has another characteristic such that the ON voltage thereof becomes low since voltage drop in the n-type base layer 1 becomes small due to the long life time of carriers in the n-type base layer 1.

However, the thickness of the n-type base layer 1 must be increased in order to obtain high breakdown voltage. For example, the thickness of the n-type base layer 1 must be over 500 $\mu$m for the breakdown voltage of 4500 V. In the gate turn-off thyristor having such a thick n-type base layer 1, it takes long time to draw out carriers accumulated in the vicinity of the middle of the n-type base layer through the $n^+$-type shorting layer 5, and hence the turn off time of the gate turn-off thyristor becomes long. In the gate turn-off thyristor having the thick n-type base layer 1, further, carriers remaining in the vicinity of a junction defined by the n-type base layer 1 and the p-type base layer 2 must be discharged to the gate electrode 7 through the p-type base layer 2, at the time of turn-off operation. This discharge takes relatively long time, and hence a storage time in the turn-off time of the gate turn-off thyristor disadvantageously becomes relatively long. Thus, it is difficult to shorten the turn-off time of the gate turn-off thyristor having the n-type base layer 1 which is enlarged in thickness in order to obtain a high breakdown voltage, even if the anode shorted structure is employed.

## SUMMARY OF THE INVENTION

In the first aspect, a gate turn-off thyristor according to the present invention comprises a first conductivity type first base layer having first and second major surfaces, a second conductivity type first emitter layer formed on said first major surface of said first base layer, a first conductivity type shorting layer formed on said first major surface of said first base layer, a second conductivity type second base layer formed on said second major surface of said first base layer, a first conductivity type second emitter layer formed in a surface of said second base layer, an anode electrode formed on said first emitter layer and said shorting layer for short-circuitting said first emitter layer and said shorting layer, a gate electrode formed on said second base layer, a cathode electrode formed on said second emitter layer, and a damage layer formed in a predetermined depth portion of said first base layer for trapping carriers in said first base layer.

In the second aspect, a gate turn-off thyristor according to the present invention comprises a first conductivity type first base layer having first and second major surfaces, a second conductivity type first emitter layer formed on said first major surface of said first base layer, a second conductivity type second base layer formed on said second major surface of said first base layer, a first conductivity type second emitter layer formed in a surface of said second base layer, an anode electrode formed on said first emitter layer, a gate electrode formed on said second base layer, a cathode electrode formed on said second emitter layer, a first damage layer formed in a predetermined depth portion of said first base layer for trapping carriers in said first base layer, and a second damage layer formed in said first base layer near a junction defined by said first base layer and said first emitter layer for trapping carriers in said first base layer

Accordingly, it is an object of the present invention to provide a gate turn-off thyristor which can have short turn-off time even if the thickness of a first base layer of the thyristor is increased.

These and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a cross-sectional view showing a conventional gate turn-off thyristor having an anode shorted structure: and

Fig. 2 to Fig. 6 are cross-sectional views showing embodiments of a gate turn-off thyristor according to the present invention.

DETAILED DESCRIPTION OF THE INVENTION

Fig. 2 is a cross-sectional view showing an embodiment of a gate turn-off thyristor having an anode shorted structure in accordance with the present invention. Referring to Fig. 2, p-type emitter layers 24 and $n^+$-type shorting layers 25 are alternately formed on one major surface of an n-type semiconductor substrate serving as an n-type base layer 21. The n-type base layer 21 has a damage layer 29 for trapping carriers, in the middle portion of the n-type base layer 21. An anode electrode 26, which is provided on the p-type emitter layers 24 and the $n^+$-type shorting layers 25, short-circuits the p-type emitter layers 24 and the $n^+$-type shorting layers 25. In other words, the n-type base layer 21 is short-circuited with the anode electrode 26 through the $n^+$-type shorting layers 25. The n-type base layer 21 is provided with a p-type base layer 22 on the other major surface of the n-type base layer 21. The p-type base layer 22 is provided with n-type emitter layers 23 in the surface of the p-type base layer 22. Gate electrodes 27 and cathode electrodes 28 are formed on and in ohmic contact with the p-type base layer 22 and the n-type emitter layers 23, respectively.

The manufacuturing method of the gate turn-off thyristor illustrated in Fig. 2 will now be described. First, the n-type semiconductor substrate serving as the n-type base layer 21 is prepared. N-type impurities are implanted from one major surface of the n-type base layer 21 thereinto, to form an $n^+$-type layer on one major surface of the n-type base layer 21. Then, the $n^+$-type layer is partially masked, and p-type impurities are implanted from both major surfaces of the n-type base layer 21 thereinto, to form the p-type emitter layers 24 on one major surface of the n-type base layer 21 and the p-type base layer 22 on the other major surface of the n-type base layer 21. At the same time, the $n^+$-type layer not converted to the p-type emitter layers 24 becomes the $n^+$-type shorting layers 25. Then, the p-type base layer 22 is partially masked, and n-type impurities are implanted into the p-type base layer 22 to form the n-type emitter layers 23. Thereafter metallization step is performed to form the anode electrode 26 on the p-type emitter layers 24 and the $n^+$-type shorting layer 25, the gate electrodes 27 on the p-type base layer 22 and the cathode electrodes 28 on the n-type emitter layers 23. Thus, the conventional gate turn-off thyristor element having the anode shorted structure is obtained.

Then, Protons or Hydrogen ions are implanted from one major surface of the element, under the condition that the center of a range is in the vicinity of the middle of the n-type base layer 21. In the ion implantation of Hydrogen ions etc., it is well known that the ion concentration becomes extremely high only in an area of several $\mu$m length where the range of ions is terminated, and the ion concentration in the other area is extremely low. Therefore, the damage layer 29 can be formed in a desired narrow range in the n-type base layer 21. The depth of the damage layer 29 in the n-type base layer 21 depends on implantation energy. The implantation energy of approximately 3 MeV is needed in order to implant Hydrogen ions to the depth of 100 $\mu$m. Although other atoms than Hydrogen such as Argon and Helium may be used, atoms with large mass need large energy for deep implantation, and hence it is preferable to use Hydrogen. The implantation quantity is preferably $10^{10}$ to $10^{12}$ per cm$^2$ for Hydrogen.

The damage layer 29 serves as a life time killer. Namely, the damage layer 29 provide recombination centers for trapping carries remaining in the vicinity of the middle of the n-type base layer 21 at the time of turn-off operation. Thus, the carriers remaining in the vicinity of the middle of the n-type base layer 21 are rapidly recombined and disappear in the damage layer 29, so that the turn-off time of the gate turn-off thyristor can be reduced.

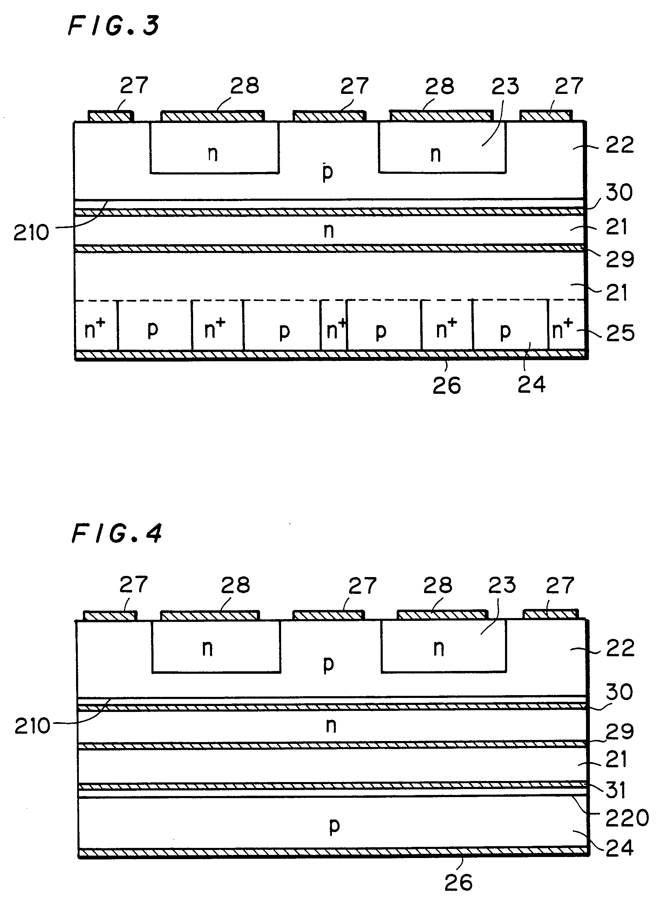

Fig. 3 is a cross-sectional view showing another embodiment of the gate turn-off thyristor according to the present invention. Referring to Fig. 3, an n-type base layer 21 has two damage layers 29 and 30. The damage layer 29 is formed through an implantation step in which the center of a range is set in the vicinity of the middle of the n-type base layer 21. The damage layer 30 is formed through another ion implantation step in which the center of a range is set at just (e.g., several μm) under a junction 210 defined by the n-type base layer 21 and a p-type base layer 22.

The damage layer 30 provides recombination centers for carriers in the vicinity of the junction 210, so that a storage time in the turn-off time and the gate reverse charge, which means time integral value of minus gate current, of the gate turn-off thyristor can be reduced. Especially, small gate reverse charge results in the advantage that small gate control power is required for turning off the thyristor. Further, carriers remaining in the vicinity of the middle of the n-type base layer 21 can be rapidly swept out by virtue of the damage layer 29, similarly to the embodiment shown in Fig. 2. Thus, smaller turn-off time is obtained.

Fig. 4 is a cross-sectional view showing still another embodiment of the gate turn-off thyristor according to the present invention. Referring to Fig. 4, the gate turn-off thyristor has no n⁺-type shorting layer. Only p-type emitter layer 24 is formed on one major surface of an n-type base layer 21. Instead, a third damage layer 31 is formed in the n-type base layer 21 near a junction 220 defined by the n-type base layer 21 and the p-type emitter layer 24, in addition to damage layers 29 and 30 similar to those shown in Fig. 3. The damage layer 31 rapidly sweeps out carriers in the vicinity of the junction 220 at the time of turn-off operation, so that the same turn-off time as the anode shorted structure shown in Fig. 3 can be obtained.

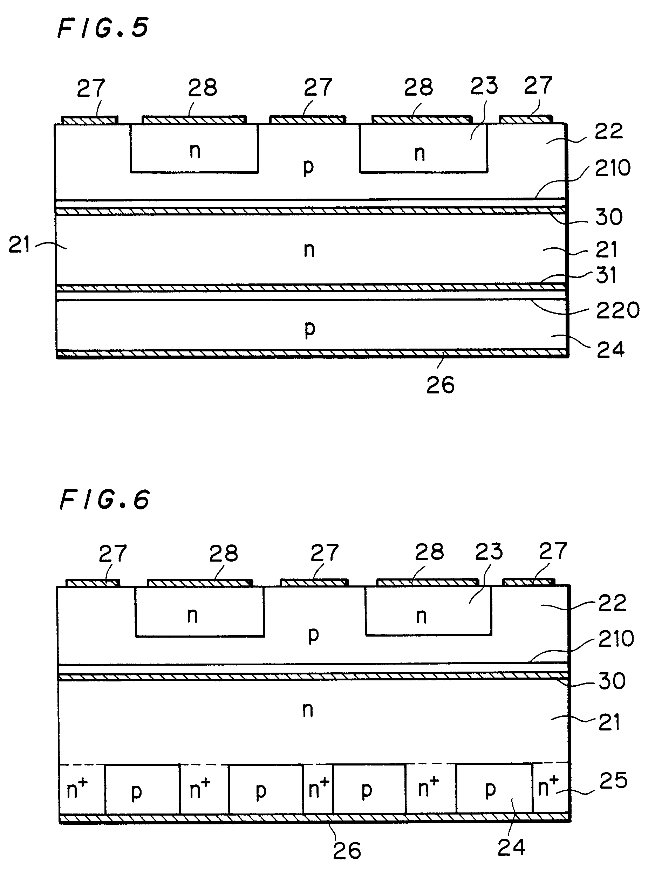

If the n-type base layer 21 is relatively thin, the damage layer 29 in the vicinity of the middle of the n-type base layer 21 is not necessarily needed in embodiments shown in Fig. 3 and Fig. 4, as shown in Fig. 5 and Fig. 6. In Fig. 5, a thin n-type base layer 21 has only two damage layers 30 and 31 near junctions 210 and 220, respectively. In Fig. 6, a thin n-type base layer 21 has only one damage layer 30 near a junction 210. The gate turn-off thyristors according to these embodiments have similar advantages to those of the embodiments shown in Fig. 3 and Fig. 4 by virtue of the damage layers 30 and 31.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A gate turn-off thyristor comprising:
a first conductivity type first base layer (21) having first and second major surfaces;
a second conductivity type first emitter layer (24) formed on the first major surface of the first base layer (21);
a first conductivity type shorting layer (25) formed on the first major surface of the first base layer (21);
a second conductivity type second base layer (22) formed on the second major surface of the first base layer (21);
a first conductivity type second emitter layer (23) formed in a surface of the second base layer (22);
an anode electrode (26) formed on the first emitter layer (24) and the shorting layer (25) for short-circuiting the first emitter layer (24) and the shorting layer (25);
a gate electrode (27) formed on the second base layer (22);
a cathode electrode (28) formed on the second emitter layer (23);
and
a damage layer (29) formed in a predetermined depth portion of the first base layer (21) for trapping carriers in the first base layer (21).

2. The gate turn-off thyristor in accordance with claim 1, wherein the predetermined depth portion of the first base layer (21) includes a portion in the vicinity of the middle of the first base layer (21).

3. The gate turn-off thyristor in accordance with claim 1, wherein the predetermined depth portion of the first base layer (21) includes a portion near a junction (210, 220) defined by the first and second base layers (21, 22).

4. The gate turn-off thyristor in accordance with claim 3, further comprising another damage layer (30) formed in the vicinity of the middle of the first base layer (21).

5. A gate turn-off thyristor comprising:
a first conductivity type first base layer (21) having first and second major surfaces;
a second conductivity type first emitter layer (24) formed on the first major surface of the first base layer (21);
a second conductivity type second base layer (22) formed on the second major surface of the first base layer (21);
a first conductivity type second emitter layer (23) formed in a surface of the second base layer (22);

an anode electrode (26) formed on the first emitter layer (24):

a gate electrode (27) formed on the second base layer (22):

a cathode electrode (28) formed on the second emitter layer (23):

a first damage layer (29) formed in a predetermined depth portion of the first base layer (21) for trapping carriers in the first base layer (21); and

a second damage layer (31) formed in the first base layer (21) near a junction (220) defined by the first base layer (21) and the first emitter layer (24) for trapping carriers in the first base layer (21).

6. The gate turn-off thyristor in accordance with claim 5, wherein the predetermined depth portion of the first base layer (21) includes a portion in the vicinity of the middle of the first base layer (21).

7. The gate turn-off thyristor in accordance with claim 5, wherein the predetermined depth portion of the first base layer (21) includes a portion near a junction defined by the first and second base layers (21, 22).

8. The gate turn-off thyristor in accordance with claim 7, further comprising a third damage layer (30) formed in the vicinity of the middle of the first base layer (21).

9. A method of manufacturing a gate turn-off thyristor comprising the steps of:

preparing a first conductivity type first base layer (21) having first and second major surfaces:

forming a second conductivity type first emitter layer (24) on the first major surface of the first base layer (21);

forming a first conductivity type shorting layer (25) on the first major surface of the first base layer (21);

forming a second conductivity type second base layer (22) on the second major surface of the first base layer (21);

forming a first conductivity type second emitter layer (23) in a surface of the second base layer (22);

forming an anode electrode (26) on the first emitter layer (24) and the shorting layer (25) for short-circuiting the first emitter layer (24) and the shorting layer (25);

forming a gate electrode (27) on the second base layer (22);

forming a cathode electrode (28) on the second emitter layer (23); and

forming a damage layer (29) in a predetermined depth portion of the first base layer (21) for trapping carriers in the first base layer (21).

10. The method of manufacturing a gate turn-off thyristor in accordance with claim 9, wherein the step of forming a damage layer (29) includes the step of implanting ions. especially Hydrogen ions into the first base layer (21).

11. A method of manufacturing a gate turn-off thyristor comprising the steps of:

preparing a first conductivity type first base layer (21) having first and second major surfaces:

forming a second conductivity type first emitter layer (24) on the first major surface of the first base layer (21);

forming a second conductivity type second base layer (22) on the second major surface of the first base layer (21);

forming a first conductivity type second emitter layer (23) in a surface of the second base layer (22);

forming an anode electrode (26) on the first emitter layer (24);

forming a gate electrode (27) on the second base layer (22);

forming a cathode electrode (28) on the second emitter layer (23);

forming a first damage layer (29, 30) in a predetermined depth portion of the first base layer (21) for trapping carriers in the first base layer (21); and

forming a second damage layer (31) in the first base layer (21) near a junction (220) defined by the first base layer (21) and the first emitter layer (24) for trapping carriers in the first base layer (21).

12. The method of manufacturing a gate turn-off thyristor in accordance with claim 11, wherein the step of forming a first damage layer (29, 30) and the step of forming a second damage layer (31) include the step of implanting ions, especially Hydrogen ions into the first base layer (21).

*FIG.1*

*FIG.2*

FIG.3

FIG.4

*FIG.5*

*FIG.6*